Europäisches Patentamt

European Patent Office

Office européen des brevets

(19)

(11)  EP 1 012 609 B1

# (12) FASCICULE DE BREVET EUROPEEN

(45) Date de publication et mention
de la délivrance du brevet:
**24.10.2001 Bulletin 2001/43**

(21) Numéro de dépôt: **98913499.4**

(22) Date de dépôt: **21.04.1998**

(51) Int Cl.⁷: $G01R\ 15/18$

(86) Numéro de dépôt international:
**PCT/CH98/00155**

(87) Numéro de publication internationale:
**WO 98/48287 (29.10.1998 Gazette 1998/43)**

(54) **DISPOSITIF DE MESURE, A LARGE BANDE PASSANTE, DE L'INTENSITE DU COURANT ELECTRIQUE DANS UN CONDUCTEUR**

GERÄT MIT BANDPASS GROSSER BANDBREITE ZUM MESSEN ELEKTRISCHER STROMSTÄRKE IN EINEM LEITER

DEVICE WITH WIDE PASS BAND FOR MEASURING ELECTRIC CURRENT INTENSITY IN A CONDUCTOR

(84) Etats contractants désignés:
**CH DE FR LI**

(30) Priorité: **21.04.1997 CH 91097**
        **22.10.1997 CH 245997**

(43) Date de publication de la demande:
**28.06.2000 Bulletin 2000/26**

(73) Titulaire: **Arbeitsgemeinschaft Prof. Dr. J. Hugel
CH-8092 Zürich (CH)**

(72) Inventeurs:
 • **KARRER, Nicolas
 CH-8002 Zurich (CH)**
 • **HOFER-NOSER, Patrick
 CH-3006 Bern (CH)**

(74) Mandataire: **WILLIAM BLANC & CIE
Conseils en Propriété Industrielle SA,
Rue du Valais 9
1202 Genève (CH)**

(56) Documents cités:
**EP-A- 0 622 635          DE-A- 3 517 095
DE-A- 3 605 719          US-A- 5 442 280**

 • **GHISLANZONI L: "MAGNETIC COUPLED CURRENT SENSING TECHNIQUES FOR SPACECRAFT POWER SYSTEMS" EUROPEAN SPACE POWER, MADRID, OCT. 2 - 6, 1989, vol. VOL. 1, no. -, 2 octobre 1989, LANDEAU J, pages 323-327, XP000163967**
 • **PATENT ABSTRACTS OF JAPAN vol. 013, no. 245 (P-881), 8 juin 1989 & JP 01 047959 A (NICHICON CORP), 22 février 1989,**

## Description

La présente invention vise à fournir un dispositif de mesure de l'intensité du courant électrique passant dans un conducteur qui permette de mesurer, avec une très bonne fidélité, aussi bien des courants continus que des courants à hautes fréquences, soit un dispositif ayant une bande passante de zéro à plus de 10 MHz.

A cet effet, le dispositif selon l'invention est caractérisé en ce qu'il comporte, d'une part, une bobine de mesure fermée sur elle-même, sans noyau magnétisable, entourant au moins partiellement ledit conducteur et étant agencée de façon à fournir un premier signal de mesure et, d'autre part, au moins une résistance de mesure parcourue par le courant à mesurer ou au moins un détecteur de champ magnétique disposé au voisinage dudit conducteur, agencés de façon à fournir un second signal de mesure, le dispositif de mesure comprenant un circuit de traitement desdits premier et second signaux de mesure de manière à fournir un signal de sortie qui est une image du courant à mesurer.

L'invention vise en outre à permettre une miniaturisation du dispositif de mesure et, selon une forme d'exécution préférée, une mesure sans couplage galvanique entre le courant à mesurer et le signal de sortie.

Des formes de réalisation particulières du dispositif selon l'invention sont indiquées dans les revendications 2 à 13, et d'autres aspects, buts et avantages de l'invention ressortiront de la description qui suit et des dessins annexés.

On connaît déjà des procédés de mesure utilisant une bobine de Rogowski, par exemple d'après la publication "Rogowski Transducers For High Current Measurement" de W. F. Ray, "IEE Colloquium on Low Frequency Power Measurement and Analysis", London, 1994, p. 10/1-10/6, et les documents FR-A-2695482 et US-A-5442280, ces procédés ne permettant toutefois pas de mesurer des courants continus ou des composantes continues du courant.

D'autres procédés de mesure du courant connus utilisent la mesure du champ magnétique créé par un conducteur parcouru par le courant, au moyen de détecteurs de champ tels que des sondes de Hall ou des éléments magnétorésistifs (cf. DE 36 05 719, DE 35 17 095, et la publication de L. Ghislanzoni "MAGNETIC COUPLED CURRENT SENSING TECHNIQUES FOR SPACECRAFT POWER SYSTEMS", Proceedings of the European Space Power Conference 2-6 October 1989, Madrid, Spain). Sans canaliser le flux au moyen de matériaux magnétiques à haute perméabilité, les signaux de mesure correspondants sont toutefois très faibles. Ainsi, les couplages capacitifs et les - champs parasitaires peuvent engendrer des signaux d'une amplitude atteignant un multiple de celle du signal de mesure, par exemple dans le cas de la commutation par des commutateurs à semi-conducteur pouvant conduire à des vitesses de variation de tension de l'ordre de plusieurs milliers de volts par microseconde. Pour augmenter le signal de mesure ainsi que le rapport signal/bruit, le conducteur peut être entouré par un circuit magnétique à entrefer. On mesure dans ce cas le champ magnétique à l'intérieur de l'entrefer, par exemple au moyen d'un dispositif de compensation réglant le flux dans le circuit magnétique à zéro par l'intermédiaire d'un bobinage supplémentaire. Toutefois, la fréquence limite supérieure de tels capteurs de courant à compensation est généralement inférieure à 1 MHz. D'autre part, la section du circuit magnétique nécessaire augmente avec l'intensité du courant à mesurer et n'offre ainsi guère de possibilités de miniaturisation.

Dans les procédés par lesquels on mesure la chute de tension sur des conducteurs ou résistances parcourus par le courant à mesurer, les pertes qui augmentent proportionnellement avec la valeur effective du courant, le couplage galvanique entre le signal de mesure et le courant à mesurer, ainsi que la construction mécanique coûteuse que ces procédés impliquent, représentent des inconvénients majeurs. Un procédé de ce type fait l'objet de la publication de Adolf Schwab "Die Berechnung der Bandbreite und der Anstiegszeit rohrförmiger koaxialer Messwiderstände unter Berücksichtigung der Stromverdrängung" (ETZ-A vol. N° 89, p. 604 ss).

La présente invention qui a pour but de remédier aux inconvénients des procédés et dispositifs susmentionnés, sera mieux comprise à la lumière de la description donnée ci-après de différentes formes de réalisation, indiquées à titre d'exemples, avec référence aux dessins annexés dans lesquels:

la Fig. 1 est un schéma de principe d'un dispositif selon l'invention;

la Fig. 2 est un schéma synoptique illustrant une première forme d'exécution;

la Fig. 3 est un schéma synoptique illustrant une autre forme d'exécution;

la Fig. 4 est un schéma d'un dispositif de mesure simple;

la Fig. 5 est un schéma détaillé d'une forme de réalisation du dispositif selon l'invention;

les Figures 6a et 6b sont des vues, respectivement de face et en coupe, d'une construction d'un dispositif selon l'invention;

La Fig. 7 est un schéma synoptique illustrant une autre forme d'exécution du dispositif selon l'invention;

La Fig. 8 est un schéma synoptique illustrant une forme d'exécution similaire à celle de la Fig. 7;

La Fig. 9 est un schéma synoptique illustrant encore une autre forme d'exécution du dispositif selon l'invention; et

La Fig. 10 est un schéma synoptique illustrant une forme d'exécution similaire à celle de la Fig. 9.

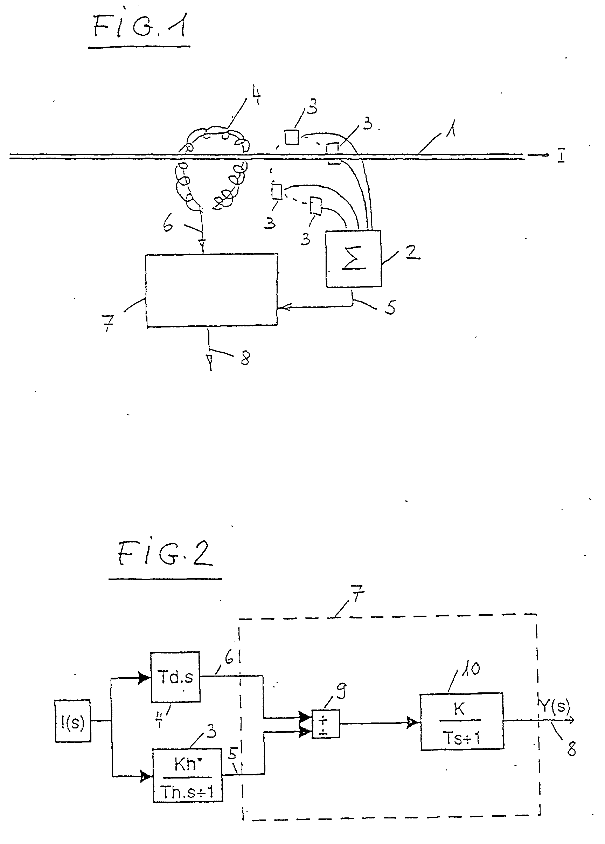

Selon le schéma de la Fig. 1, le courant $I$ passant dans un conducteur 1 est mesuré, d'une part, par une bobine 4 à air, fermée sur elle-même, disposée autour du conducteur 1, connue sous le nom de bobine de Rogowski, et, d'autre part, par plusieurs - ici quatre - détecteurs de champ magnétique 3, tels que des détecteurs à effet Hall ou des détecteurs magnétorésistifs dont les signaux de sortie sont additionnés dans un circuit 2 pour former un signal de mesure. Ce signal qui apparaît sur un conducteur 5 est amené à une première entrée d'un circuit de traitement de signaux 7, dont une autre entrée reçoit, par un conducteur 6, le signal de mesure de la bobine 4. Le signal de sortie du circuit 7 apparaît sur un conducteur 8.

Il est à noter que les détecteurs de champ sont de préférence disposés au voisinage du conducteur primaire 1 sans que le flux magnétique ne soit concentré à leur endroit par un circuit ou des éléments en un matériau magnétiquement perméable. Ceci permet d'éviter l'influence d'un tel circuit ou de tels éléments aussi bien sur le comportement du dispositif de mesure que sur le circuit primaire qui doit, dans certaines applications, pouvoir être commuté très rapidement.

La Fig. 2 illustre une forme d'exécution du présent dispositif par un schéma dans lequel les signaux sont décrits par leurs transformées de Laplace, $s$ représentant l'opérateur de Laplace, $I(s)$ la transformée de Laplace du courant $I$ à mesurer et $Y(s)$ le signal de sortie du dispositif de mesure.

La bobine de Rogowski fournit une tension proportionnelle à la vitesse de variation du courant $I$, cette tension pouvant être décrite, dans le domaine de fréquences concerné, par l'expression

$$Ur(s) = s \cdot Td \cdot I(s) \qquad (2),$$

$Td$ désignant une constante dépendant de la forme et du matériau de la bobine.

Les détecteurs de champ 3 fournissent, sur le conducteur 5, un signal à bande de fréquence limitée qui peut être décrit par

$$Uh(s) = Kh^* \cdot I(s) / (1+s\ Th) \qquad (3),$$

$Kh^*$ désignant une constante qui dépend en particulier du genre et du nombre des détecteurs de champ. Le dénominateur de l'expression 3 décrit la limitation de la bande de fréquences de ce signal.

Dans le circuit 7 de la Fig. 2, les signaux de mesure sont additionnés dans un dispositif 9 et le signal résultant est appliqué à un dispositif de retardement 10 du premier ordre à constante de temps $T$. $K$ représente l'amplification du signal dans ce dispositif. Le signal de sortie sur le conducteur 8 devient ainsi

$$Y(s) = I(s)\ [s^2 \cdot Td \cdot Th \cdot K + Td \cdot K \cdot s + Kh^* \cdot K]/[s^2 \cdot T \cdot Th + (Th+T) \cdot s + 1] \qquad (4).$$

Si l'on détermine les constantes de telle façon que le numérateur et le dénominateur du multiplicateur de $I(s)$ deviennent au moins approximativement égaux, la fonction de transfert devient au moins approximativement égale à un et $Y(s)$ représente une image fidèle de $I(s)$. Dans la plupart des cas, il suffira que la condition $Th \ll T$ soit remplie pour obtenir un signal de sortie ayant la précision souhaitée.

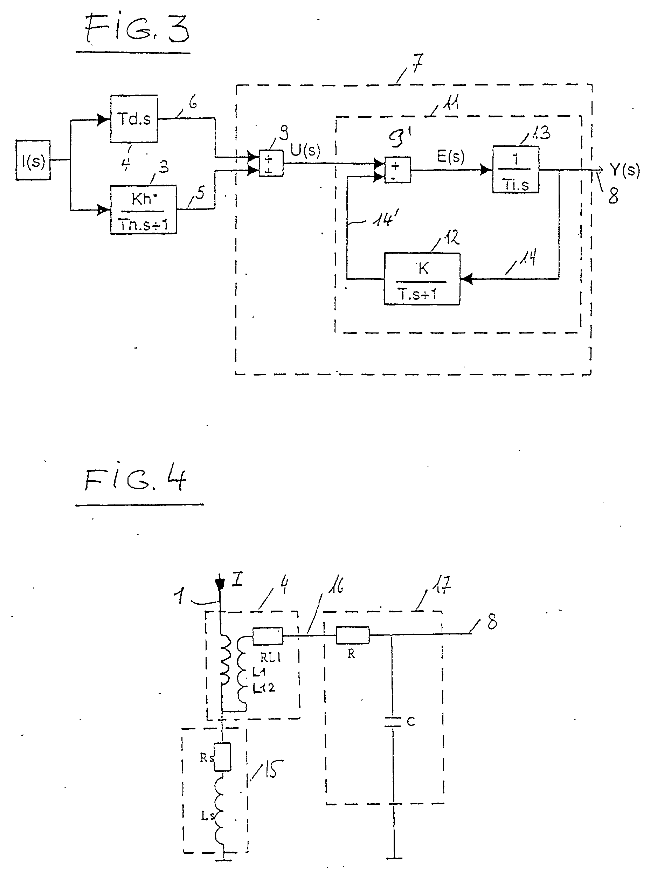

Dans la forme d'exécution plus élaborée de la Fig. 3, qui reprend les mêmes notations que celles de la Fig. 2, le dispositif 10 du circuit 7 est remplacé par un dispositif 11 à boucle de réglage. Le signal de sortie $U(s)$ du dispositif d'addition 9 est appliqué à l'entrée positive d'un dispositif de soustraction 9' dont la sortie est reliée à un dispositif d'intégration 13. La sortie de 13 est couplée avec l'entrée négative du dispositif 9' via des conducteurs 14, 14', par l'intermédiaire d'un dispositif de retardement 12 analogue au dispositif 10 de la Fig. 2. Le signal $E(s)$ est le signal d'erreur apparaissant à la sortie de 9' et la fonction de transfert du dispositif 11 a la forme suivante:

$$Y(s) / U(s) = (1+sT) / [(1+sT) \cdot s\ Ti + K] \qquad (5),$$

T désignant la constante de temps du dispositif de retardement, K l'amplification dans la boucle de réglage, et *Ti* la constante de temps d'intégration du dispositif d'intégration 13.

En utilisant les formes des signaux de mesure selon les expressions (2) et (3) ci-dessus, on peut calculer la fonction de transfert du dispositif de mesure qui devient

$$Y(s)/I(s)= [s·Td(1+s·Th)+Kh^*](1+s·T) \, / \, \{(1+sTh)[s·Ti·(1+s·T)+K]\} \tag{6}.$$

S'il est possible de choisir les paramètres de telle façon que les conditions *Td = Ti*, *T = Th* et K = *Kh\** soient remplies, la valeur de cette fonction de transfert devient égale à un et le signal de sortie une image fidèle du courant à mesurer. La fréquence limite supérieure est déterminée par l'agencement de la bobine de Rogowski et du dispositif intégrateur. La fréquence limite inférieure est égale à zéro.

La Fig. 4 montre un dispositif de mesure très simple selon le schéma de la Fig. 2 dans lequel les signaux de mesure sont additionnés par la connexion en série de la bobine 4 et d'une résistance de mesure 15. La bobine de Rogowski 4 présente une résistance interne *RL1*, une auto-inductance *L1* et une inductance mutuelle *L12*. La résistance de mesure 15 présente une valeur ohmique *Rs* et une inductance propre *Ls*. La somme de la chute de tension dans la résistance 15 et de la tension induite dans la bobine 4 apparaît sur le conducteur 16 et est appliquée à un dispositif de retardement du premier ordre 17, soit en l'occurrence un filtre passe-bas formé par une résistance R et un condensateur C. Sur le conducteur 8 apparaît un signal de sortie de la forme

$$Y(s) = I(s)· [s(L12+Ls)+Rs] \, / \, [s^2 C(L1+Ls) + sC \, (RL1+Rs+R)+1] \tag{7}.$$

S'il est possible de choisir les constantes de telle façon que la fonction de transfert *Y(s) / I(s)*, soit au moins approximativement égale à un, le signal de sortie devient une image fidèle de *I(s)*. L'inconvénient majeur d'un tel dispositif est le couplage galvanique entre le conducteur 1 du courant à mesurer et le conducteur de sortie 8.

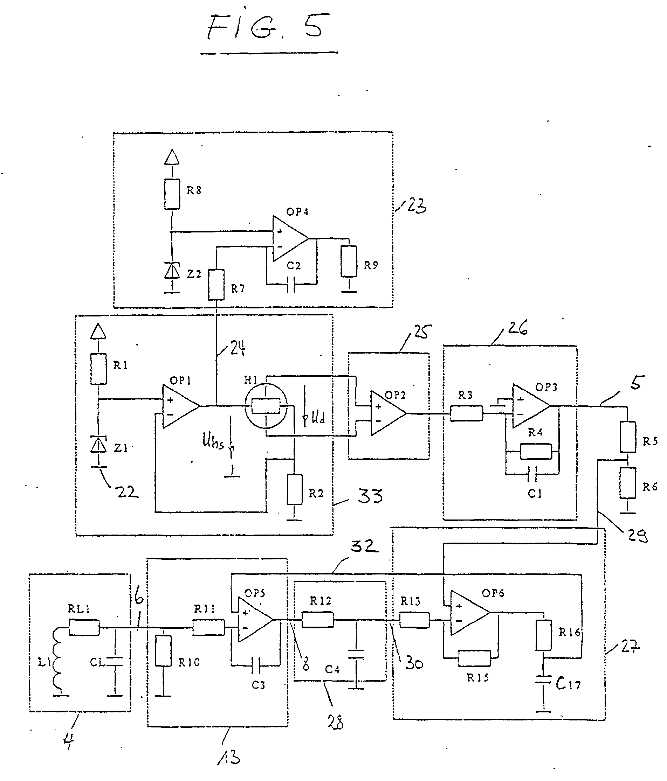

La forme d'exécution représentée plus en détail à la Fig. 5 réalise une fonction de transfert analogue à celle de la Fig. 3 et les éléments analogues sont désignés par les mêmes chiffres de référence que précédemment. Des détecteurs de champ magnétique sous forme de sondes de Hall, qui correspondent aux détecteurs 3 de la Fig. 1 et dont une seule, H1, est représentée dans un bloc 33, fournissent chacune une tension *Ud* proportionnelle aux composantes à basses fréquences du courant *I* passant dans le conducteur 1 de la Fig. 1. Les tensions de sortie des différentes sondés de Hall sont amplifiées dans des amplificateurs respectifs tels que OP2 représenté dans un bloc 25, puis additionnées d'une manière non représentée. Le signal résultant est appliqué à un dispositif de retardement du premier ordre avec amplification 26 comprenant une résistance R3 et un amplificateur opérationnel OP3 avec les résistances *R4* et *C1*. La fréquence limite du dispositif 26 étant nettement plus basse que la fréquence limite du signal des détecteurs 33, la fonction de transfert de l'ensemble 33, 25 et 26, fournissant sur le conducteur 5 l'un des signaux de mesure du dispositif, peut s'écrire

$$Gh(s) = -Kh·R4·Kd/[R3(1+s·C1·R4)] \tag{8},$$

où la constante *Kh* représente l'amplification propre des sondes de Hall et *Kd* l'amplification dans le bloc 25.

L'autre signal de mesure est fourni par la bobine de Rogowski représentée dans le bloc 4 par son inductance *L1*, sa résistance ohmique *RL1* et sa capacité interne *CL*. Le signal sur le conducteur 6 est fourni au bloc 13 qui forme un dispositif intégrateur avec soustraction et comporte des résistances *R10*, *R11* et un amplificateur opérationnel OP5 avec un condensateur *C3*. Pour obtenir une intégration suffisamment rapide, l'amplificateur opérationnel OP5 doit avoir une très large bande passante et peut être constitué, par exemple, par un amplificateur composé par des éléments appelés "Diamond Transistor" selon la nomenclature de la société Burr Brown (Applications Handbook 1994, pages 257 ss), par un amplificateur-transimpédance ou encore par une unité amplificatrice à large bande composée de plusieurs amplificateurs. L'impédance d'entrée de l'amplificateur OP5 doit être adaptée à la bobine de Rogowski, cette adaptation pouvant éventuellement être réalisée au moyen d'un circuit passif.

Sur le conducteur 8, à la sortie du bloc 13, apparaît le signal de sortie du dispositif de mesure. Ce signal est fourni en outre, de façon similaire au schéma de la Fig. 3, par l'intermédiaire d'un dispositif de retardement 28, constitué par un filtre passe-bas comprenant une résistance *R12* et un condensateur *C4,* à un dispositif 27 dont le signal de sortie est ramené à l'amplificateur OP5 par une liaison 32 aboutissant à l'entrée positive de cet amplificateur. Le dispositif 27 forme la différence entre le signal *Ur* apparaissant sur le conducteur 30 et le signal *Uh* apparaissant sur le conducteur 29 après division, par les résistances *R5* et *R6,* du signal de mesure sur le conducteur 5. Des résistances *R13*, *R15* et *R16* ainsi qu'un condensateur *C17* font partie du dispositif 27, comme le montre le schéma de la Fig. 5, les valeurs de *R16* et *C17* étant respectivement égales à celles de *R11* et *C3*.

La fonction de transfert *Y(s)* / *I(s)* du dispositif de la Fig. 5 devient ainsi

$$Y(s)/I(s)=-\{[s \cdot L1 \cdot R10(1+s(C1 \cdot R4)/(R10+RL1)]+Kh \cdot Kd \cdot R4 \cdot R6(R13+R15) \,/$$

$$R3 \cdot R13 \cdot (R6+R5)\} \,(1+s.C4.R12) \,/$$

$$\{(1 + s.C1.R4)[s.C3.R11.(1+s.C4.R12) + R15/R13]\} \tag{9}.$$

La comparaison avec les coefficients de l'expression (6) montre que

$$Td = L1.R10/(R10+RL1)$$

$$Kh^* = Kh \cdot Kd \cdot R4 \cdot R6 \cdot (R13+R15)/[R3 \cdot R13 \cdot (R6+R5)]$$

$$Th = C1 \cdot R4$$

$$Ti = C3 \cdot R11$$

$$T = C4 \cdot R12$$

$$K = R15 \,/\, R13$$

D'après la Fig. 5, le signal de sortie est inversé par rapport au signal d'entrée. Le signe du signal de sortie peut être inversé par un dispositif inverseur à la sortie, ou par une inversion des entrées de l'intégrateur.

Le schéma de la Fig. 5 montre également l'alimentation des sondes de Hall à partir d'une source de courant constant réalisée par le schéma du bloc 33 où R1 et R2 sont des résistances, Z1 une diode Zener et OP1 un amplificateur opérationnel. Les chemins d'alimentation des différentes sondes de Hall sont connectés en série. Le courant d'alimentation étant constant, la tension apparaissant à la sortie de l'amplificateur opérationnel 1 par rapport à la masse 22, Uhs, est proportionnelle à la température des sondes de Hall et peut être utilisée pour la commande d'un dispositif de réglage de la température 23. Le dispositif 23 comporte une résistance de chauffage R9 comprenant le montage en série ou en parallèle de plusieurs résistances partielles alimentées à partir d'un amplificateur opérationnel OP4, le cas échéant, par l'intermédiaire d'un dispositif amplificateur de puissance. La valeur de consigne de la température est déterminée par un diviseur de tension comprenant une résistance R8 et une diode Zener Z2. La tension Uhs est amenée par un conducteur 24 et une résistance R7 à l'entrée négative de l'amplificateur opérationnel OP4 / C2. Selon une forme d'exécution alternative, un détecteur de température séparé pourrait fournir le signal de commande pour le dispositif 23. D'autres moyens de stabilisation de la température peuvent également être utilisés, tels que par exemple un pont de mesure comprenant la sonde de Hall et, en série, une résistance sensible à la température ayant la même caractéristique en fonction de la température, la différence de potentiel dans la diagonale du pont formant le signal *Ud*.

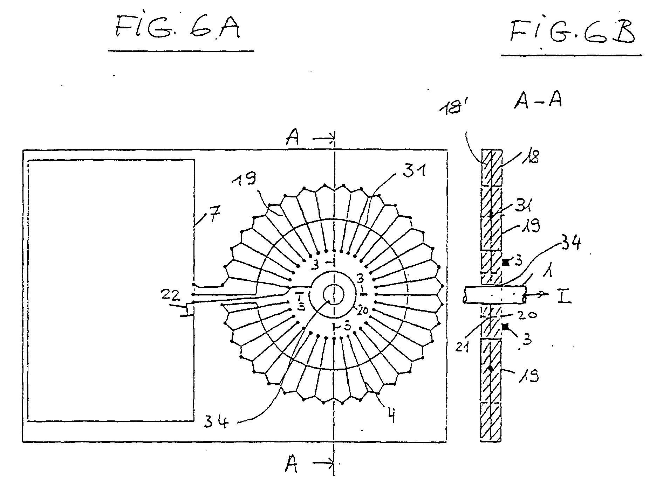

Les Figures 6a et 6b montrent une forme de construction préférée du dispositif de mesure selon l'invention. La bobine de Rogowski 4 est réalisée sous forme de circuit imprimé 19 sur un substrat, par exemple en deux parties 18, 18' réunies, le conducteur de retour 31 de la bobine pouvant ainsi être disposé au centre du bobinage. Des sondes de Hall ou autres détecteurs de champ magnétique 3 sont disposés sur le même substrat et repartis régulièrement autour de l'ouverture centrale 34 par laquelle passe le conducteur 1. Le dispositif comporte en outre une piste conductrice 20 entourant l'ouverture 34, avec des parties de contact 21 traversant le substrat, l'ensemble étant relié à la masse pour former un blindage contre des couplages capacitifs parasitaires. La bobine de Rogowski 4 présente une structure homogène pour minimiser l'influence de champs parasitaires extérieurs. Le circuit électronique 7 de traitement des signaux est de préférence réalisé sur le même substrat que la bobine de Rogowski et les détecteurs de champ. Les pistes conductrices peuvent être formées sur un substrat rigide ou flexible et sont de préférence configurées de telle façon qu'elles forment un ensemble d'un seul tenant permettant d'ouvrir le dispositif pour son installation autour du conducteur 1.

Les formes d'exécution du circuit de traitement de signaux décrites plus haut, visent à résoudre le problème de la mesure de courants continus au moyen d'un dispositif permettant de mesurer des courants à hautes fréquences, soit une bobine de Rogowski ou une bobine à air. En effet, une telle bobine ne fournissant pas de signal de mesure à la fréquence zéro, le dispositif d'intégration habituellement utilisé devrait maintenir son signal de sortie constant au voisinage de ce point. Or, le dispositif d'intégration n'a pas un comportement idéal. Il comprend généralement un ou plusieurs amplificateurs opérationnels qui doivent avoir une bande passante aussi large que possible, des courants de fuite et de polarisation extrêmement faibles et un domaine de variation des tensions d'entrée et de sortie très large. D'autre part, ces amplificateurs présentent généralement une amplification très élevée au voisinage de la fréquence zéro, Le signal de sortie aura donc pratiquement toujours tendance à dériver.

La solution selon les Fig. 3 et 5 qui consiste à effectuer une mesure du champ magnétique engendré par le courant pour obtenir un second signal de mesure dans de domaine des basses fréquences, et à utiliser une boucle de réglage pour compenser ce défaut inhérent du dispositif d'intégration, s'avère être relativement coûteuse et difficile à réaliser sur le plan industriel, notamment du fait de sa dépendance de la température et du problème de la stabilité de la boucle de réglage.

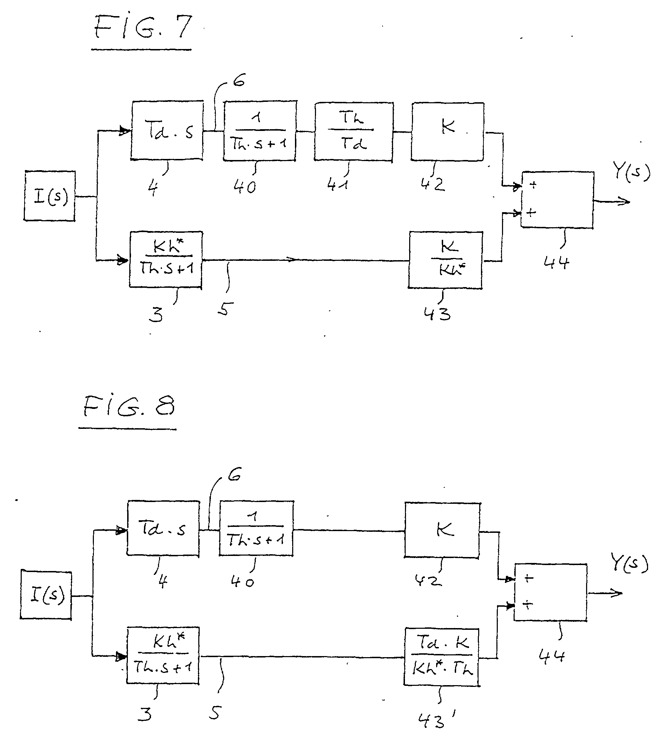

Les figures 7 à 10 illustrent une solution alternative permettant d'éviter l'utilisation d'un dispositif d'intégration à comportement aussi proche que possible du comportement idéal et d'obtenir par des moyens relativement simples un signal de sortie $Y(s)$ proportionnel au courant à mesurer $I(s)$ dans un domaine de fréquences allant de zéro à la fréquence de résonance de la bobine de mesure.

Les schémas synoptiques des figures 7 et 8 montrent respectivement deux variantes de réalisation de cette solution dans lesquelles les sources de signaux sont considérées comme idéales, de façon analogue à la Fig. 2, et les mêmes chiffres de référence et symboles sont utilisés pour les éléments et signaux correspondant à ceux de la Fig. 2.

Selon la Fig. 7, le signal de mesure 6 est appliqué à un dispositif de retardement du premier ordre 40 et ensuite à des éléments d'amplification 41, 42 séparés ou réunis. Dans le cas où le dispositif 40 est un élément actif, les fonctions d'amplification de 41 et 42 peuvent être réalisées par ce même élément.

Le signal de mesure 5 est amplifié ou réduit dans le dispositif 43 selon le choix de la constante K en fonction de l'amplitude souhaitée pour le signal de sortie.

Les signaux ainsi transformés sont additionnés dans un dispositif d'addition 44 pour fournir le signal de sortie $Y(s)$.

Selon la Fig. 8, la fonction d'amplification de l'élément 41 de la Fig. 7 est reprise, de façon inverse, dans l'élément amplificateur / réducteur 43' disposé à la place de l'élément 43 de la Fig. 7.

On constate aisément que la fonction de transfert du dispositif de mesure devient dans le cas de la Fig. 7, $Y(s) / I(s) = K$ et dans le cas de la Fig. 8, $Y(s) / I(s) = K. Td/Th.$

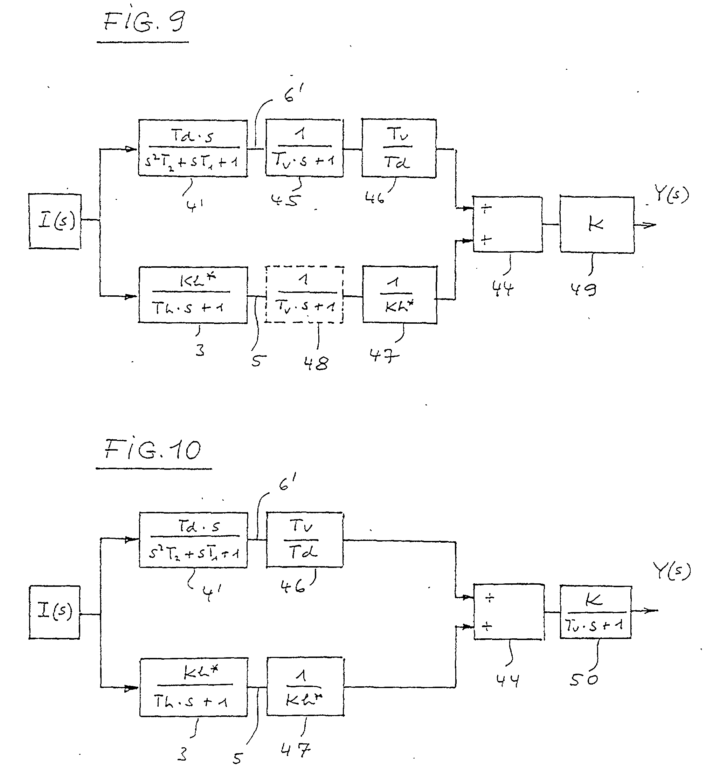

Les figures 9 et 10 illustrent deux autres variantes d'un tel dispositif de mesure, la bobine de mesure étant représentée par une fonction de transfert selon l'expression figurant dans les blocs 4', constituant une approximation jusqu'à des fréquences supérieures à quelques dizaines de MHz. En effet, une bobine de Rogowski ou bobine à air, présente un comportement idéal de différentiateur jusqu'à des fréquences d'environ 100 MHz, selon l'exécution de la bobine. Pour les fréquences plus élevées, le couplage capacitif entre les spires lui confère un comportement d'intégrateur.

Pour le fonctionnement du dispositif de mesure, il est important que la fréquence limite supérieure jusqu'à laquelle la bobine agit comme élément différentiateur soit plus grande que la fréquence limite du détecteur de champ qui possède une caractéristique de filtre passe-bas. Cette condition est généralement remplie dans le cas des détecteurs à effet Hall actuels et d'une bobine de Rogowski bien conçue.

Dans le schéma de la Fig. 9, le signal de mesure 6' est appliqué à un dispositif de retardement du premier ordre 45 ayant une constante de temps Tv, et il est soumis à une amplification d'un facteur $Tv/Td$ dans le bloc 46, cette fonction pouvant être incorporée dans le dispositif 45. Le signal de mesure 5 peut être appliqué directement à un élément amplificateur / réducteur 47, si $Tv = Th$.

Dans le cas où la fréquence limite du détecteur 3 est située deux ou trois décades au-dessus de celle du dispositif 45, on peut utiliser un retardement par un dispositif 48 identique au dispositif 45. La réalisation de deux dispositifs identiques pouvant s'avérer difficile, on préférera généralement un circuit selon la Fig. 10.

Les signaux transformés sont additionnés dans un dispositif 44 et amplifiés, par exemple par le dispositif 49 de la Fig. 9. Bien entendu, cette fonction peut également être incorporée dans le dispositif 44 ou dans les dispositifs 46 et 47.

Dans la forme d'exécution selon la Fig. 10, le retardement est effectué à la sortie du dispositif d'addition 44, par exemple par un dispositif actif 50 qui produit le retardement ainsi qu'une amplification d'un facteur K. Les fonctions des autres blocs de même nom sont analogues à celles de la Fig. 9.

Dans les exécutions pratiques, du fait du comportement non idéal des sources de signaux de mesure et des autres éléments du dispositif de mesure, le signal de sortie ne sera pas une image parfaite du courant à mesurer dans tout le domaine de fréquences. Toutefois, la caractéristique de fréquence d'un tel dispositif correspond à celle d'un filtre passe-bas avec une fréquence limite aux alentours de la fréquence de résonance de la bobine de Rogowski. Une résistance d'amortissement est de préférence connectée à la sortie de cette bobine pour amortir le signal à la fréquence de résonance.

La solution décrite à l'aide des exemples des figures 7 à 10, permet ainsi de réaliser une fonction de transfert constante dans un très large domaine de fréquences, y compris la fréquence zéro, au moyen de dispositifs aisément maîtrisables et d'un prix de revient peu élevé.

Des mesures comparatives effectuées avec un dispositif selon l'invention et avec un transformateur de courant commercial ayant une fréquence limite supérieure de 20 MHz, ont permis de constater que les propriétés dynamiques respectives ne présentaient pas de différences. D'autre part, une mesure en courant continu jusqu'à 300 A montrait une erreur maximale de 2% par rapport à la mesure au moyen d'une résistance de mesure à haute précision.

**Revendications**

1. Dispositif de mesure de l'intensité du courant électrique passant dans un conducteur, comportant, d'une part, une bobine de mesure fermée (4) sur elle-même, sans noyau magnétisable, entourant au moins partiellement ledit conducteur (1) et étant agencée de façon à fournir un premier signal de mesure et, d'autre part, au moins une résistance de mesure (15) parcourue par le courant à mesurer ou au moins un détecteur de champ magnétique (3) disposé au voisinage dudit conducteur (1), agencés de façon à fournir un second signal de mesure, le dispositif comportant un circuit de traitement (2, 7) desdits premier et second signaux de mesure de manière à fournir un signal de sortie qui est une image du courant à mesurer.

2. Dispositif selon la revendication 1, **caractérisé en ce que** ladite bobine est une bobine de Rogowski (4) et ledit détecteur de champ magnétique est un détecteur à effet Hall (3) ou un élément magnétorésistif, le dispositif ne comprenant pas d'éléments en matériau magnétiquement perméable pour canaliser le flux magnétique à travers ledit détecteur.

3. Dispositif selon la revendication 1 ou la revendication 2, **caractérisé en ce qu'**il comporte plusieurs éléments détecteurs de champ magnétique (3) disposés régulièrement autour dudit conducteur électrique (1).

4. Dispositif selon les revendications 2 et 3, **caractérisé en ce que** la bobine de Rogowski (4) est réalisée sur un substrat porteur (18, 18') de conducteurs électriques (19) formant un bobinage régulier autour d'une ouverture centrale (34) et un conducteur de retour médian (31) sensiblement circulaire, les détecteurs de champ magnétique (3) étant montés sur le même substrat que la bobine.

5. Dispositif selon la revendication 4, **caractérisé en ce que** ledit substrat (18, 18') comporte un conducteur de blindage (20) entourant ladite ouverture de passage (34) sans former une boucle complète,

6. Dispositif selon la revendication 5, **caractérisé en ce que** le conducteur de blindage (20) est relié à des parties conductrices (21) traversant ledit substrat (18, 18').

7. Dispositif selon la revendication 4, **caractérisé en ce que** le substrat est formé d'au moins deux couches (18, 18') juxtaposées portant les spires de la bobine de Rogowski, le conducteur de retour (31) de celle-ci étant disposé le long des centres des spires, dans le plan de contact des deux couches.

8. Dispositif selon la revendication 4, **caractérisé en ce que** lesdits conducteurs forment ensemble d'un seul tenant de manière à permettre l'ouverture du substrat pour l'introduction du conducteur du courant à mesurer.

9. Dispositif selon la revendication 1, **caractérisé en ce qu'**il comporte un dispositif d'addition (9) formant la somme desdits signaux de mesure, la sortie de ce dispositif d'addition étant reliée à une première entrée d'un dispositif de soustraction (9'), la sortie de ce dispositif de soustraction étant reliée à un dispositif d'intégration (13), le signal apparaissant à la sortie de ce dispositif d'intégration étant couplé, par l'intermédiaire d'un dispositif de retardement (12), à une seconde entrée dudit dispositif de soustraction (9'), de manière à former une boucle de réglage telle que le signal de sortie du dispositif de mesure apparaissant à la sortie de l'intégrateur soit proportionnel à l'intensité du courant à mesurer.

**10.** Dispositif selon la revendication 1, **caractérisé en ce qu'**il comporte un premier dispositif d'amplification et de retardement (26) connecté à la sortie dudit détecteur de champ (33) ou aux bornes de ladite résistance de mesure, pour former ledit premier signal de mesure, un dispositif d'intégration (13) dont la sortie est reliée à un second dispositif d'amplification et de retardement (28), et un dispositif d'addition/soustraction (27)dont la sortie est reliée à l'entrée dudit dispositif d'intégration (13) et dont les entrées sont reliées, respectivement, à la sortie dudit premier dispositif d'amplification et de retardement (26), à la sortie dudit second dispositif d'amplification et de retardement (28), et à la sortie de ladite bobine (4) fournissant ledit second signal de mesure, de manière à former une boucle de réglage telle que le signal de sortie du dispositif de mesure apparaissant à la sortie de l'intégrateur soit proportionnel à l'intensité du courant à mesurer.

**11.** Dispositif selon la revendication 1, **caractérisé en ce qu'**il comporte un dispositif d'addition (44) desdits signaux de mesure, le cas échéant après une amplification ou réduction appropriée de l'un et/ou de l'autre de ces signaux, et un dispositif de retardement du premier ordre (50) connecté à la sortie dudit dispositif d'addition, les amplifications ou réductions des signaux de mesure et la constante de temps dudit dispositif de retardement étant choisies de façon à ce que le signal de sortie du dispositif de retardement soit- proportionnel à l'intensité du courant à mesurer.

**12.** Dispositif selon la revendication 1, **caractérisé en ce qu'**il comporte un dispositif de retardement du premier ordre (50) connecté à la sortie de ladite bobine de mesure (4), un dispositif d'addition de signaux (44) et au moins un dispositif d'amplification ou réduction (42; 43) disposé entre la sortie dudit dispositif de retardement et une première entrée dudit dispositif d'addition et/ou entre la sortie dudit détecteur de champ magnétique et une seconde entrée dudit dispositif d'addition, les amplifications ou réductions et la constante de temps dudit dispositif de retardement étant choisies de façon à ce que le signal de sortie du dispositif d'addition soit proportionnel à l'intensité du courant à mesurer.

**13.** Dispositif selon la revendication 11 ou la revendication 12, **caractérisé en ce que** ledit détecteur de champ magnétique présente une fréquence limite supérieure qui est plus basse que la fréquence de résonance propre de ladite bobine de mesure.

**Patentansprüche**

**1.** Messvorrichtung zur Erfassung des in einem Leiter fliessenden Stroms, welche einerseits eine in sich geschlossene, den Leiter (1) zumindest teilweise umschliessende Messpule (4) ohne magnetisierbaren Kern aufweist welche so angeordnet ist, dass sie ein erstes Messignal liefert, und andererseits mindestens einen Messwiderstand (45) aufweist, welcher vom zu messenden Strom durchsetzt wird, oder mindestens einen Magnetfelddetektor (3), der in der Nähe des Leiters (1) angebracht ist, aufweist und so angeordnet ist, dass sie ein zweites Messignal liefert, wobei die Messvorrichtung eine Schaltung (2, 7) zur Bearbeitung des ersten und zweiten Messignals aufweist, um ein Ausgangssignal zu liefern, welches ein Abbild des zu messenden Stromes ist.

**2.** Vorrichtung nach Patentanspruch 1, **dadurch gekennzeichnet, dass** die Spule eine Rogowski-Spule (4) ist und der Magnetfelddetektor eine Hall-Sonde (3) oder eine Feldplatte ist, wobei die Vorrichtung keine Elemente aus magnetisch permeablem Material zur Kanalisierung des magnetischen Flusses durch die Magnetfelddetektoren enthält.

**3.** Vorrichtung nach Patentanspruch 1 oder 2, **dadurch gekennzeichnet, dass** sie mehrere Magnetfelddetektoren (3) aufweist, die gleichmässig um den Stromleiter (1) angeordnet sind.

**4.** Vorrichtung nach Patentansprüchen 2 und 3, **dadurch gekennzeichnet, dass** die Rogowski-Spule (4) auf einem Substrat (18, 18') realisiert ist, auf dem elektrische Leiterbahnen (19) aufgebracht sind, die als regelmässige Wicklung um eine Öffnung (34) in der Mitte angeordnet sind und einen kreisförmigen, mittleren Rückleiter (31) besitzen, wobei die Magnetfelddetektoren (3) auf dem gleichen Substrat wie die Spule montiert sind.

**5.** Vorrichtung nach Patentanspruch 4, **dadurch gekennzeichnet, dass** das Substrat (18, 18') einen Abschirmungsleiter (20) aufweist, welcher die Durchführungsöffnung (34) umrandet, ohne eine geschlossene Schleife zu bilden.

**6.** Vorrichtung nach Patentanspruch 5, **dadurch gekennzeichnet, dass** der Abschirmungsleiter (20) mit leitenden Teilen (21) verbunden ist, welche das Substrat (18, 18') durchqueren.

7. Vorrichtung nach Patentanspruch 4, **dadurch gekennzeichnet, dass** das Substrat aus mindestens zwei gegenüberstehenden Lagen (18, 18') gebildet ist, welche die Wicklungen der Rogowski-Spule tragen, wobei deren Rückleiter (31) in der Berührungsfläche der zwei Lagen entlang der Mitte der Windungen angeordnet ist.

8. Vorrichtung nach Patentanspruch 4, **dadurch gekennzeichnet, dass** die Leiter zusammen eine Gesamtheit bilden, so dass das Substrat geöffnet werden kann, um ein Einführen des zu messenden Stromleiters zu ermöglichen.

9. Vorrichtung nach Patentanspruch 1, **dadurch gekennzeichnet, dass** sie eine Additionsvorrichtung aufweist, welche die Summe der Messignale bildet, wobei der Ausgang dieser Additionsvorrichtung mit einer ersten Subtraktionsvorrichtung (9') verbunden ist, der Ausgang dieser Subtraktionsvorrichtung mit einer Integrationsvorrichtung (13) verbunden ist, und das Ausgangssignal dieser Integrationsvorrichtung mittels einer Verzögerungsvorrichtung (12) mit einem zweiten Eingang der Subtraktionsvorrichtung (9') verbunden ist, um einen Regelkreis zu bilden, so dass das am Ausgang des Integrators erscheinende Ausgangssignal der Messvorrichtung proportional zur zu messenden Stromstärke sei.

10. Vorrichtung nach Patentanspruch 1, **dadurch gekennzeichnet, dass** sie eine erste Verstärker- und Verzögerungsvorrichtung (26) aufweist, welche mit dem Magnetfelddetektorausgang (33) oder den Anschlüssen des Messwiderstandes verbunden ist, um ein erstes Messignal zu bilden, eine Integrationsvorrichtung (13), deren Ausgang mit einer zweiten Verstärker und Verzögerungsvorrichtung verbunden ist, und eine Additions-/ Substraktionsvorrichtung (27), deren deren Ausgang mit dem Eingang der Integrationsvorrichtung (13) verbunden ist, und deren Eingänge jeweils mit dem Ausgang der ersten Verstärker- und Verzögerungsvorrichtung (26), mit dem Ausgang der zweiten Verstärker- und Verzögerungsvorrichtung (28) und mit dem Ausgang der das zweite Messignal liefernden Spule (4) verbunden sind, um einen Regelkreis zu bilden, so dass das am Ausgang des Integrators erscheinende Ausgangssignal der Messvorrichtung proportional zur zu messenden Stromstärke sei.

11. Vorrichtung nach Patentanspruch 1, **dadurch gekennzeichnet, dass** sie eine Vorrichtung (44) zur Addition des Messignals, gegebenenfalls nach einer geeigneten Verstärkung oder Abschwächung des einen und/oder des anderen dieser Signale, aufweist, sowie eine mit dem Ausgang der Additionsvorrichtung verbundene Vorrichtung zur Verzögerung erster Ordnung (50), wobei die Verstärkung und Abschwächung der Messignale und die Zeitkonstante der Verzögerungsvorrichtung so gewählt sind, dass das Ausgangssignal der Verzögerungsvorrichtung proportional zur zu messenden Stromstärke sei.

12. Vorrichtung nach Patentanspruch 1, **dadurch gekennzeichnet, dass** sie eine mit dem Ausgang der Messpule (4) verbundene Verzögerungsvorrichtung erster Ordnung (50) sowie eine Signaladditionsvorrichtung (44) und mindestens eine Verstärker- oder Abschwächvorrichtung (42; 43) aufweist, welche zwischen dem Ausgang der Verzögerungsvorrichtung und einem ersten Eingang der Additionsvorrichtung und/oder zwischen dem Ausgang des Magnetfeldetektors und einem zweiten Eingang der Additionsvorrichtung angebracht sind, wobei die Verstärkung oder Abschwächung und die Zeitkonstante der Verzögerungsvorrichtung so gewählt sind, dass das Ausgangssignal der Additionsvorrichtung proportional zur zu messenden Stromstärke sei.

13. Vorrichtung nach Patentanspruch 11 oder 12, **dadurch gekennzeichnet, dass** die Magnetfelddetektoren eine obere Bandgrenze aufweisen, welche tiefer ist als die Eigenfrequenz der Messpule.

**Claims**

1. Device for measuring the intensity of electric current passing through a conductor, **characterized in that** it comprises, on the one hand, a measuring coil (4) closed on itself, without a magnetizable core, surrounding said conductor (1) at least partially and adapted to provide a first measurement signal and, on the other hand, at least one measuring resistor (15) through which the current to be measured flows, or at least one magnetic field detector (3) arranged in the vicinity of said conductor (1), adapted to provide a second measurement signal, the device comprising a circuit (2, 7) to process said first and second measurement signals to provide an output signal which is the image of the current to be measured.

2. Device according to claim 1, **characterized in that** said coil is a Rogowski (4) coil and said magnetic field detector is a Hall (3) effect detector or a magneto-resistive element, the device not comprising elements of magnetically permeable material for channelling the magnetic flux across said detector.

3. Device according to claim 1 or claim 2, **characterized in that** it comprises a plurality of magnetic field (3) detecting elements arranged regularly around said electric conductor (1).

4. Device according to claims 2 and 3, **characterized in that** the Rogowski (4) coil is provided on a substrate (18, 18') carrying electric conductors (19) forming a regular coil around a central opening (34) and a substantially circular median return coil (31), the magnetic field detectors (3) being assembled on the same substrate as the coil.

5. Device according to claim 4, **characterized in that** said substrate (18, 18') comprises a shielding conductor (20) surrounding said opening passage (34) without forming a complete loop.

6. Device according to claim 5, **characterized in that** the shielding conductor (20) is connected to conducting portions (21) extending across said substrate (18, 18').

7. Device according to claim 4, **characterized in that** the substrate is formed from at least two juxtaposed layers (18, 18') carrying the winding turns of the Rogowski coil, the return conductor (31) of the latter being arranged along the middle of the turns, in the plane of contact of the two layers.

8. Device according to claim 4, **characterized in that** said conductors form an integral assembly adapted to enable the substrate to be opened for inserting the conductor of the current to be measured.

9. Device according to claim 1, **characterized in that** it comprises an adding device (9) forming the sum of said measurement signals, the output of this adding device being connected to the first input of a subtracting device (9'), the output of this subtracting device being connected to an integrating device (13), the signal appearing at the output of this integrating device being coupled, through a delay device (12), to a second input of said subtracting device (9'), so as to form a control loop such that the output signal of the measuring device appearing at the output of the integrator is proportional to the intensity of current.

10. Device according to claim 1, **characterized in that** it comprises a first amplification and delay device (26) connected to the output of said field detector (33) or to the terminals of said measuring resistor, to provide said first measurement signal, an integrating device (13) whose output is connected to a second amplification and delay device (28), and an adding / subtracting device (27) whose output is connected to the input of said integrating device (13) and whose inputs are connected, respectively, to the output of said first amplification and delay device (26), and to the output of said second amplification and delay device (28), and to the output of said coil (4) providing the said second measurement signal, in such a way as to form a control loop, such that the output signal of the measuring device appearing at the output of the integrator is proportional to the intensity of the current .

11. Device according to claim 1, **characterized in that** it comprises an adding device (44) of said measurement signals, as the case may be after an appropriate amplification or reduction of one and/or of the other of these signals, and a first order delay device (50) connected to the output of said adding device, the amplifications or reductions of measurement signals and the time constant of said delay device being chosen in such a way that the output signal of the delay device is proportional to the intensity of current.

12. Device according to claim 1, **characterized in that** it comprises a first order delay device (50) connected to the output of said measuring coil (4), a signal adding device (44) and at least one amplification or reduction device (42, 43) arranged between the output of said delay device and a first input of said adding device and/or between the output of said magnetic field detector and a second input of said adding device, the amplifications and reductions and the time constant of said delay device being chosen in such a way that the output signal of the adding device is proportional to the intensity of the current to be measured.

13. Device according to claim 11 or claim 12, **characterized in that** said magnetic field detector has an upper frequency limit lower than the resonance frequency of said measuring coil.

FIG.1

FIG.2

FIG. 3

FIG. 4

# FIG. 5

FIG. 6A

FIG. 6B

A – A

## FIG. 7

$$\boxed{T_d \cdot s}_{\;4} \quad \boxed{\dfrac{1}{T_h \cdot s + 1}}_{\;40} \quad \boxed{\dfrac{T_h}{T_d}}_{\;41} \quad \boxed{K}_{\;42}$$

$$I(s)$$

$$6$$

$$\boxed{\dfrac{K_h^*}{T_h \cdot s + 1}}_{\;3} \qquad \boxed{\dfrac{K}{K_h^*}}_{\;43}$$

$$5 \qquad 44 \qquad Y(s)$$

## FIG. 8

$$\boxed{T_d \cdot s}_{\;4} \quad \boxed{\dfrac{1}{T_h \cdot s + 1}}_{\;40} \qquad \boxed{K}_{\;42}$$

$$I(s)$$

$$6$$

$$\boxed{\dfrac{K_h^*}{T_h \cdot s + 1}}_{\;3} \qquad \boxed{\dfrac{T_d \cdot K}{K_h^* \cdot T_h}}_{\;43'}$$

$$5 \qquad 44 \qquad Y(s)$$

## FIG. 9

## FIG. 10